# EUROPÄISCHE PATENTSCHRIFT

(11) **EP 1 393 435 B1**
(45) Veröffentlichungstag und Bekanntmachung des Hinweises auf die Patenterteilung: **25.02.2009**
(21) Anmeldenummer: 02745103.8
(22) Anmeldetag: 29.05.2002
(51) Int. Cl.: H03B 5/04, H03B 5/12

(54) **KOMPENSIERTE OSZILLATORSCHALTUNG**
COMPENSATED OSCILLATOR CIRCUIT
CIRCUIT OSCILLATEUR COMPENSE

(30) Priorität: 31.05.2001 DE 10126608
(43) Veröffentlichungstag der Anmeldung: 03.03.2004
(73) Patentinhaber: Infineon Technologies AG, 81669 München (DE)
(72) Erfinder: FEILKAS, Klaus-Jürgen, 81675 München (DE); GELTINGER, Hans, 83727 Schliersee (DE); MOREIRA, Jose, Pedro, 80333 München (DE)
(74) Vertreter: Epping - Hermann - Fischer
(86) Internationale Anmeldenummer: PCT/DE2002/001996
(87) Internationale Veröffentlichungsnummer: WO 2002/097965

(56) Entgegenhaltungen:
- US-A- 6 133 801
- US-A- 6 137 375
- PATENT ABSTRACTS OF JAPAN vol. 1996, no. 07, 31. Juli 1996 (1996-07-31) & JP 08 065048 A (SANYO ELECTRIC CO LTD), 8. März 1996 (1996-03-08)
- PATENT ABSTRACTS OF JAPAN vol. 017, no. 061 (E-1316), 5. Februar 1993 (1993-02-05) & JP 04 267607 A (NIPPON STEEL CORP), 24. September 1992 (1992-09-24)

## Beschreibung

Die vorliegende Erfindung betrifft eine kompensierte Oszillatorschaltung.

Als Oszillatoren werden üblicherweise Signalgeneratoren bezeichnet, mit denen Sinusschwingungen erzeugt werden können. Bei LC-Oszillatoren wird die Frequenz durch einen Schwingkreis mit einer Induktivität und einer Kapazität bestimmt. Die einfachste Methode, eine Sinusschwingung zu erzeugen, besteht in der Entdämpfung eines LC-Schwingkreises mit Hilfe eines Verstärkers.

Die prinzipielle Anordnung eines derartigen Oszillators ist beispielsweise in Tieze, Schenk: Halbleiter-Schaltungstechnik, 10. Auflage 1993, Seiten 458 ff. angegeben.

Um höhere Leistungen und bessere Wirkungsgrade zu erreichen, sind Oszillatoren üblicherweise als Gegentaktoszillatoren aufgebaut, bei denen zur Entdämpfung zwei kreuzgekoppelte Transistoren vorgesehen sind, wobei die Kreuzkopplung beispielsweise eine galvanische, eine kapazitive oder eine induktive beziehungsweise transformatorische Mitkopplung sein kann.

Um variable Frequenzen erzeugen zu können, ist es weiterhin üblich, die integrierte Kapazität des LC-Schwingkreises steuerbar auszuführen, beispielsweise in Form einer Varaktordiode.

Werden Oszillatorschaltungen als integrierte Schaltungen aufgebaut, so ergeben sich zwangsläufig bei üblichen Fertigungsverfahren Prozeßschwankungen, welche beispielsweise Kapazitätswert-Toleranzen von plus/minus 20% mit sich bringen. Derartige Abweichungen von Nennwerten der verwendeten Bauelemente verursachen Amplitudenabweichungen des Ausgangssignals der Oszillators, welche unerwünscht sind.

Es ist bekannt, den Bias-Strom der im Entdämpfungsverstärker vorgesehenen Transistoren, beispielsweise MOS-Feldeffekt-Transistoren, so nachzuführen, daß die Steilheit der Transistoren in kompensierender Weise angepaßt ist. Hierfür ist üblicherweise eine abhängige Stromquelle vorgesehen, welche jedoch das Phasenrauschen des Oszillators erhöht. Zudem führt das kompensierende Nachführen des Bias-Stromes der Transistoren zu einer Arbeitspunktverstellung und damit zu einer verschlechterten Aussteuerbarkeit des Transistors.

In dem Dokument US 6,118,348 ist ein Quarz-Oszillatorschaltkreis angegeben. Es sind mehrere, parallelgeschaltete Inverterstufen vorgesehen, die ein- und ausgangsseitig mit einem Schwingquarz verbunden sind. Ein Steuersignalgenerator, der mit den Inverterstufen gekoppelt ist, schaltet zwischen verschiedenen Verstärkungen um. Das Umschalten erfolgt derart verzögert, daß geringes Rauschen im Ausgangssignal auftritt.

Aufgabe der vorliegenden Erfindung ist es, eine kompensierte Oszillatorschaltung zur Kompensierung fertigungsbedingter Toleranzen von Nennwerten der verwendeten Bauelemente und dadurch bedingter Abweichungen der Amplitude des Ausgangssignals bei zugleich guten Phasenrausch-Eigenschaften der Oszillatorschaltung anzugeben.

Erfindungsgemäß wird die Aufgabe gelöst mit einer kompensierten Oszillatorschaltung, aufweisend
- einen Schwingkreis,
- mehrere Entdämpfungsverstärker, die mit dem Schwingkreis zu dessen Entdämpfung schaltbar gekoppelt sind und
- je einen Schalter, der je einem Entdämpfungsverstärker zugeordnet und mit diesem zur Bildung je eines wirksam schaltbaren Strompfades zwischen dem Schwingkreis und einem Versorgungspotentialanschluß gekoppelt ist, wobei die Strompfade je eine Serienschaltung aus dem je einen Schalter, dem je einen Entdämpfungsverstärker und einer Stromquelle zum Speisen des je einen Entdämpfungsverstärker umfassen.

Mit den getrennt voneinander zu- und abschaltbaren Entdämpfungsverstärkern kann sowohl der Bias-Strom der Verstärker als auch das Kanalweiten- zu Kanallängenverhältnis der gesamten Oszillatorschaltung und damit die Steilheit der Verstärkung verändert und damit an toleranzbedingte Abweichungen der Bauelementwerte von Nennwerten zum Erzielen einer gleichbleibenden Amplitude des Ausgangssignals des Oszillators herangezogen werden. Dadurch, daß nicht nur der Bias-Strom der Transistoren verändert wird, ist die Abhängigkeit sowohl des Versorgungsstroms als auch des Arbeitspunkts der Transistoren von den tatsächlichen Bauelement-Werten verringert. Dabei werden die Entdämpfungsverstärker unabhängig voneinander wirksam in die Oszillatorschaltung hinein- oder weggeschaltet, um die gewünschte Schwingungsamplitude am Ausgang der Schaltung zu erhalten, beziehungsweise um fertigungsbedingte Abweichungen von einer gewünschten Schwingungsamplitude zu kompensieren.

Die Amplitude des Ausgangssignals der Oszillatorschaltung nimmt mit zunehmender Transistorsteilheit der Entdämpfungsverstärkertransistoren zu. Die Steilheit ist dabei ungefähr proportional zur Wurzel aus dem Produkt von Bias-Strom und dem Kanalweiten- zu Kanallängenverhältnis der Transistoren.

Insgesamt erlaubt die vorliegende Anordnung eine deutliche Verringerung von Abweichungen vom idealen Arbeitspunkt des Oszillatorverstärkers, daß heißt des Entdämpfungsverstärkers. Insgesamt sind damit Performance-Einbußen auf Grund von Abweichungen verwendeter Bauelemente von Nennwerten deutlich verringert.

Gemäß der vorliegenden Erfindung umfassen die Strompfade je eine Stromquelle zum speisen der Entdämpfungsverstärker.

In einer bevorzugten Ausführungsform der vorliegenden Erfindung weisen die Schalter je einen Steueranschluß auf, der mit einer Ansteuerschaltung verbunden ist.

Mit der Ansteuerschaltung ist damit in einfacher Weise eine bestimmte Kombination von Entdämpfungsverstärkern auswählbar, um damit die gewünschte Gesamtsteilheit der Entdämpfung des Oszillators einzustellen und schließlich damit die gewünschte Amplitude des Oszillatorsignals zu erzielen.

In einer weiteren, bevorzugten Ausführungsform der vorliegenden Erfindung ist eine Regelschleife gebildet, mit einer Amplitudenwerterfassung, die eingangsseitig an den Schwingkreis und ausgangsseitig an die Ansteuerschaltung angeschlossen ist.

Durch Bildung einer Regelschleife ist ein automatischer Abgleich fertigungsbedingter Bauteiltoleranzen durch Messung der Amplitude und Ein- beziehungsweise Ausschalten entsprechender Entdämpfungsverstärker in kompensierender Weise ermöglicht.

In einer weiteren, bevorzugten Ausführungsform der vorliegenden Erfindung sind die Strompfade mit den Entdämpfungsverstärkern in einer Parallelschaltung miteinander an den Schwingkreis angeschlossen.

In einer weiteren, bevorzugten Ausführungsform der vorliegenden Erfindung umfassen die Entdämpfungsverstärker jeweils zwei kreuzgekoppelte Transistoren.

Die Kreuzkopplung der Transistoren kann bei Verwendung von Feldeffekttransistoren durch Überkreuz-Verbinden von je einem Gateanschluß eines Transistors des Transistorpaares mit je einem Drainanschluß eines weiteren Transistors des Transistorpaares erfolgen.

Die Kopplung kann dabei unmittelbar galvanisch, kapazitiv oder transformatorisch sein. Die Source-Anschlüsse eines Transistorpaares sind unmittelbar miteinander in einem Source-Knoten verbunden und an eine zu- und abschaltbare Stromquelle angeschlossen. Hierdurch ergibt sich ein schaltbarer Strompfad zum Speisen der Entdämpfungsverstärker.

In einer weiteren, bevorzugten Ausführungsform der vorliegenden Erfindung sind die Transistoren der Entdämpfungsverstärker MOSFET-Transistoren, die ein paarweise gleiches Kanalweiten- zu Kanallängen-Verhältnis haben, wobei das Kanalweiten- zu Kanallängen-Verhältnis der Entdämpfungsverstärker untereinander binär abgestuft ist.

Die binäre Abstufung der die Steilheit beeinflussenden Kanalweiten- zu Kanallängen-Verhältnisse ermöglicht bei verhältnismäßig geringem Bauteil- und Flächenbedarf eine gute Kompensationsmöglichkeit der fertigungsbedingten Bauteiltoleranzen.

Je nach Einsatzgebiet beziehungsweise Anwendung der Oszillatorschaltung können selbstverständlich auch andere Abstufungen der Transistorverhältnisse der Entdämpfungsverstärker zueinander sinnvoll sein.

In einer weiteren, bevorzugten Ausführungsform der vorliegenden Erfindung sind die Schalter als digital angesteuerte Transistorschalter ausgebildet. Transistorschalter sind in CMOS- bzw. BiCMOS-Halbleitertechnik in einfacher Weise implementierbar und zudem einfach ansteuerbar.

In einer weiteren, bevorzugten Ausführungsform der vorliegenden Erfindung hat der Schwingkreis einen Steuereingang zum Steuern der Schwingfrequenz. Der Schwingkreis ist üblicherweise als LC-Schwingkreis ausgeführt, dabei ist bevorzugt die Induktivität fest und die Kapazität steuerbar ausgebildet, beispielsweise als Varaktor, die mit einer Steuerspannung ansteuerbar ist.

Weitere Einzelheiten der Erfindung sind Gegenstand der Unteransprüche.

Die Erfindung wird nachfolgend an mehreren Ausführungsbeispielen an Hand der Zeichnungen näher erläutert. Darin bezeichnen gleiche Bezugszeichen Bauteile mit gleichem Aufbau und/oder gleicher Funktionsweise.

Es zeigen:
- Figur 1: ein erstes Ausführungsbeispiel der vorliegenden Erfindung an Hand eines Blockschaltbildes,
- Figur 2: ein vereinfachtes Schaltbild einer zweiten Ausführungsform der vorliegenden Erfindung und
- Figur 3: ein Schaltbild einer dritten Ausführungsform der vorliegenden Erfindung.

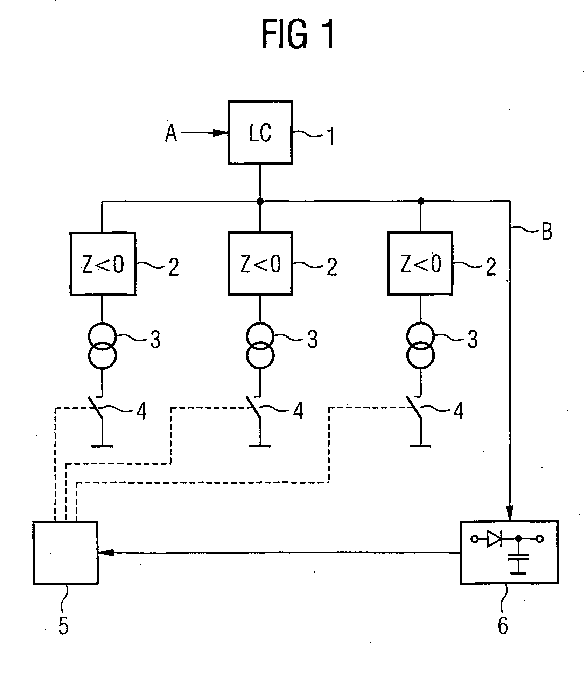

Figur 1 zeigt das Prinzip der kompensierten Oszillatorschaltung an Hand eines vereinfachten Blockschaltbildes mit einem LC-Resonator 1, dem eine Steuerspannung A zum Einstellen einer gewünschten Schwingfrequenz zuführbar ist. Über drei parallel geschaltete Strompfade, welche jeweils einen Entdämpfungsverstärker 2, eine Stromquelle 3, sowie einen Schalter 4 in je einer Serienschaltung angeordnet umfassen, ist der LC-Resonator 1 an ein Bezugspotential angeschlossen. Die Entdämpfungsverstärker 2 weisen zum Bereitstellen eines schwingungsfähigen Systems jeweils eine negative Impedanz auf.

Die Schalter 4 sind mit ihren Steueranschlüssen an eine gemeinsame Ansteuerschaltung 5 angeschlossen. Mit der Ansteuerschaltung können demnach jeweils unabhängig voneinander ein, zwei oder drei beliebige Strompfade zum Resonator 1 wirksam hinzu- oder weggeschaltet werden. Durch Unterbrechen der Strompfade mit Schalter 4 wird jeweils die Zuführung des Speisestroms der Entdämpfungsverstärker 2 unterbrochen.

Weiterhin ist zur Bereitstellung einer automatischen Regelung ein Amplitudendetektor 6 vorgesehen, der mit seinem Eingang an einen Ausgang der Oszillatorschaltung angeschlossen ist, und dem somit das Oszillator-Ausgangssignal B zugeführt wird. Der Amplitudendetektor 6 ist mit seinem Ausgang an einen Eingang der Ansteuerschaltung 5 angeschlossen.

Auf Grund von bei Massenherstellungsverfahren immer unvermeidlichen Fertigungs-Toleranzen bezüglich der Bauteil-Werte der verwendeten Bauteile, beispielsweise Kapazitäten, Widerstände etc. treten am Oszillator-Ausgangssignal B Abweichungen der Signalamplitude von einer Soll-Amplitude auf. Diese Abweichungen werden in der Ansteuerschaltung 5 ausgewertet und in Abhängigkeit der Abweichungen der bereitgestellten Amplitude von einem Sollwert werden die Schalter 4 der einzelnen Strompfade so angesteuert, daß am Ausgang des Oszillators die gewünschte Soll-Amplitude selbst oder eine Amplitude mit lediglich geringer Abweichung von der Soll-Amplitude eingestellt ist.

Durch Zuschalten einzelner Entdämpfungsverstärker 2 ist die Steilheit der Gesamtverstärkung in gewünschter Weise einstellbar. Hierdurch ist eine Verschiebung des Arbeitspunktes durch ausschließliches Anpassen des Bias-Stromes der Entdämpfungsverstärker vermieden, welches zu einer Verschlechterung der Aussteuerbarkeit sowie der Rauscheigenschaften führen würde.

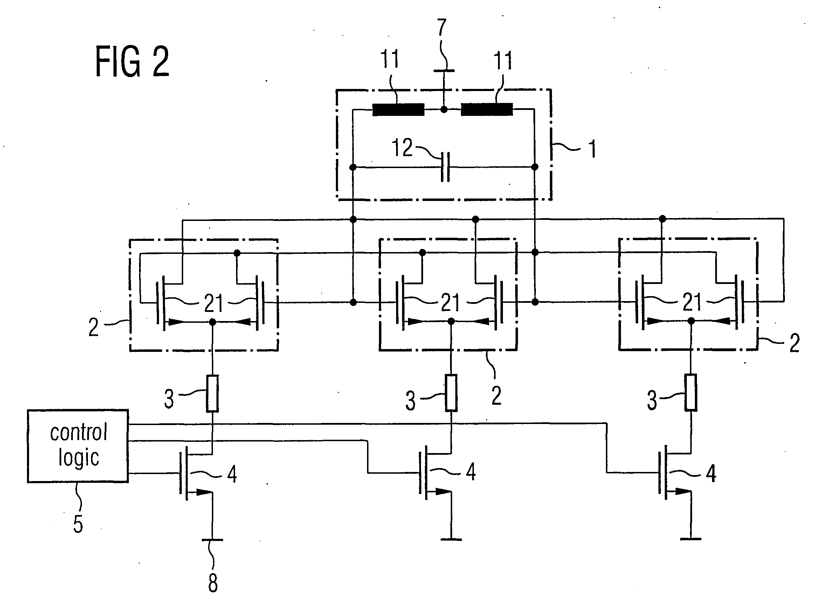

Figur 2 zeigt ein zweites Ausführungsbeispiel einer kompensierten Oszillatorschaltung, welche abgesehen von der Rückkopplung mit Amplitudendetektor 6 der im Blockschaltbild von Figur 1 gezeigten Struktur entspricht, jedoch als Gegentaktoszillator ausgebildet ist. Hierfür ist der LC-Resonator 1 mit zwei Induktivitäten 11 ausgeführt, die mit je einem Anschluß an einem ersten Versorgungspotentialanschluß 7 angeschlossen und mit einem zweiten Anschluß an je einen Anschluß einer Kapazität 12 angeschlossen sind.

Die Entdämpfungsverstärker 2 weisen jeweils zwei paarweise kreuzgekoppelte MOSFET-Transistoren 21 auf, die Sourceanschlußseitig unmittelbar miteinander verbunden und die mit je einem Steueranschluß an je einen Anschluß der Kapazität 12 angeschlossen sind. Zudem sind die Transistoren 21 galvanisch kreuzgekoppelt, in dem je ein Gate-Anschluß eines der beiden Transistoren mit je einem Source-Anschluß des anderen Transistors im Entdämpfungsverstärker 2 verbunden ist. Es sind beispielhaft insgesamt drei Entdämpfungsverstärker 2 vorgesehen, welche jeweils in gleicher Weise parallel an den LC-Resonator 1 angeklemmt sind. Source-seitig sind in jedem Signalpfad 2, 3, 4 ein Paar von Transistoren 21 über eine als Widerstand ausgebildete Stromquelle 3 an einen Drain-Anschluß eines als Schalter 4 betriebenen MOS-Feldeffekttransistors angeschlossen, dessen Source-Anschluß mit einem weiteren Versorgungspotentialanschluß 8 verbunden ist. Der Gate-Anschluß des Schalttransistors 4 ist jeweils mit einer Ansteuerschaltung 5 verbunden.

Zur Einstellung der Amplitude eines Ausgangssignals des beschriebenen Oszillators können wahlweise die Strompfade 2, 3, und/oder 4 mit der Ansteuerschaltung 5 durch entsprechendes Schalten der Schalter 4 unabhängig voneinander zu- oder weggeschaltet werden. Hierdurch ist die Steilheit der gesamten Entdämpfung im Oszillator einstellbar. Denn durch Zu- oder Abschalten der Speiseströme der Entdämpfungsverstärker 2 kann das Kanalweiten- zu Kanallängenverhältnis der Gesamtentdämpfung eingestellt werden. Dabei bleibt der gewünschte, optimale Arbeitspunkt der Verstärker erhalten.

Somit ist mit einfachen schaltungstechnischen Mitteln eine Kompensation fertigungsbedingter Toleranzen und ein Vermeiden einer Amplituden-Abweichung des Ausgangssignals des Oszillators bei zugleich guten Phasen-Rauscheigenschaften der Schaltung möglich.

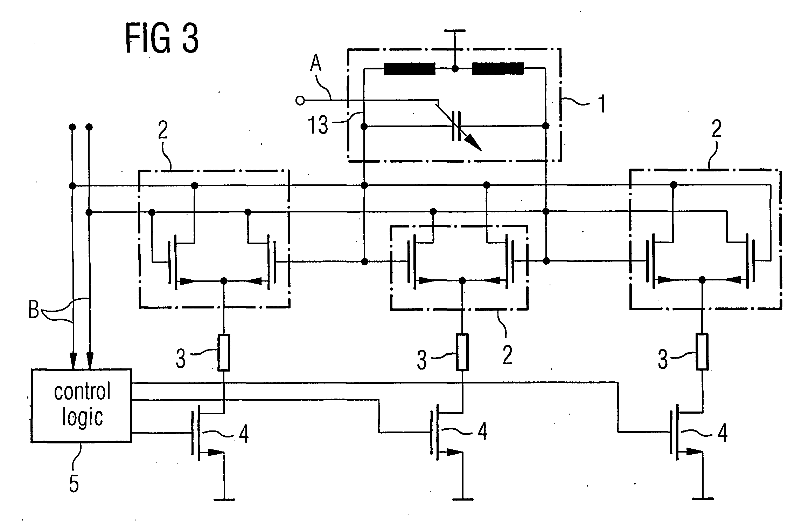

Figur 3 zeigt eine Weiterbildung der Schaltung gemäß Figur 2 als spannungsgesteuerter Oszillator. Hierfür weist der Resonator 1 einen Steuereingang zum Zuführen einer Steuerspannung A auf, die einer abstimmbaren Kapazität 13 zuführbar ist, die lastseitig verschaltet ist wie der Kondensator 12 von Figur 2. Der Kapazitätswert der Kapazität 13 ist demnach abhängig von der angelegten Steuerspannung A. Die abstimmbare Kapazität 13 kann beispielsweise mit zwei Varaktordioden gebildet sein.

Weiterhin ist der steuerbare Oszillator von Figur 3 dahingehend weitergebildet, daß eine Rückkopplung des Oszillator-Ausgangssignals B auf die Ansteuerschaltung 5 durch Verbinden des symmetrischen Ausgangsanschlusses des Resonators 1 mit der Ansteuerschaltung 5 vorgesehen ist. Demnach kann ein automatischer Abgleich toleranzbedingter Veränderungen der Amplitude des Ausgangssignals B dadurch erfolgen, daß die Ansteuerschaltung 5 eine Abweichung der tatsächlichen Amplitude des Signals B von einer Soll-Amplitude ermittelt und in Abhängigkeit von dieser Abweichung die Schalter 4 ansteuert. Die Soll-Amplitude kann beispielsweise in einem Speicher in der Ansteuerschaltung 5 abgelegt sein. Mit dem Schalter 4 ist wie bereits für Figuren 1 und 2 beschrieben die Steilheit der Entdämpfung der Oszillatorschaltung einstellbar. Hierfür können die Schalter 4 getrennt voneinander zu- oder abgeschaltet werden. Die übrigen, in Figur 3 gezeigten Schaltungsblöcke beziehungsweise Bauelemente und deren Anordnung und Funktion entsprechen den in Figur 2 bereits beschriebenen und sollen daher an dieser Stelle nicht noch einmal wiederholt werden.

Anstelle der gezeigten, galvanischen Kreuzkopplung der Transistorpaare 21 in den Entdämpfungsverstärker 2 kann selbstverständlich auch eine andere, beispielsweise eine kapazitive oder eine transformatorische Kopplung vorgesehen sein. Anstelle der Widerstände können die Stromquellen 3 auch mit aufwendigeren Stromquellen aufgebaut sein.

Der LC-Resonator 1 kann anstelle der gezeigten auch eine andere Struktur haben, wie sie üblicherweise bei LC-Varaktoren bekannt sind.

### Bezugszeichenliste

- 1: LC-Resonator
- 2: Entdämpfungsverstärker
- 3: Stromquelle
- 4: Schalter
- 5: Ansteuerschaltung
- 6: Amplitudendetektor
- 7: Versorgungspotentialanschluß
- 8: Versorgungspotentialanschluß
- 11: Induktivität
- 12: Kondensator
- 13: Abstimmbare Kapazität
- 21: Transistor
- A: Steuerspannung
- B: Oszillator-Ausgangssignal

## Patentansprüche

1. Kompensierte Oszillatorschaltung, aufweisend:
- einen Schwingkreis (1)
- mehrere Entdämpfungsverstärker (2), die jeweils mit dem Schwingkreis (1) zu dessen Entdämpfung schaltbar gekoppelt sind und
- je einen Schalter (4), der je einem Entdämpfungsverstärker (2) zugeordnet und mit diesem zur Bildung je eines wirksam schaltbaren Strompfades (2, 3, 4) zwischen dem Schwingkreis (1) und einem Versorgungspotentialanschluß (8) gekoppelt ist,
**dadurch gekennzeichnet dass** die Strompfade (2, 3, 4) je eine Serienschaltung aus dem je einen Schalter (4), dem je einen Entdämpfungsverstärker und einer Stromquelle (3) zum Speisen des je einen Entdämpfungsverstärker (2) umfassen.

2. Oszillatorschaltung nach Anspruch 1,
**dadurch gekennzeichnet, daß**
die Schalter (4) je einen Steueranschluß aufweisen, der mit einer Ansteuerschaltung (5) verbunden ist.

3. Oszillatorschaltung nach Anspruch 1 oder 2,
**dadurch gekennzeichnet, daß**
eine Regelschleife gebildet ist mit einer Amplitudenwerterfassung (6), die eingangsseitig an den Schwingkreis (1) und ausgangsseitig an die Ansteuerschaltung (5) angeschlossen ist.

4. Oszillatorschaltung nach einem der Ansprüche 1 bis 3,
**dadurch gekennzeichnet, daß**
die Strompfade (2, 3, 4) mit den Entdämpfungsverstärkern (2) in einer Parallelschaltung miteinander an den Schwingkreis (1) angeschlossen sind.

5. Oszillatorschaltung nach einem der Ansprüche 1 bis 4,
**dadurch gekennzeichnet, daß**
die Entdämpfungsverstärker (2) je zwei kreuzgekoppelte Transistoren (21) umfassen.

6. Oszillatorschaltung nach Anspruch 5,
**dadurch gekennzeichnet, daß**
die Transistoren (21) der Entdämpfungsverstärker (2) Feldeffekt-Transistoren sind, die ein paarweise gleiches Kanalweiten- zu Kanallängenverhältnis haben, wobei das Kanalweiten- zu Kanallängenverhältnis der Entdämpfungsverstärker (2) untereinander binär abgestuft ist.

7. Oszillatorschaltung nach einem der Ansprüche 1 bis 6,
**dadurch gekennzeichnet, daß**
die Schalter (4) als digital angesteuerte Transistorschalter ausgebildet sind.

8. Oszillatorschaltung nach einem der Ansprüche 1 bis 7,
**dadurch gekennzeichnet, daß**
der Schwingkreis (1) einen Steuereingang zum Steuern der Schwingfrequenz mit einer Steuerspannung (A) hat.

## Claims

1. Compensated oscillator circuit, having
- a resonant circuit (1)
- two or more attenuation compensation amplifiers (2), which are each coupled switchably to the resonant circuit (1) to compensate for its attenuation, and
- in each case one switch (4), which is associated with in each case one attenuation compensation amplifier (2) and is coupled to the attenuation compensation amplifier (2) in order to form in each case one effectively switchable current path (2, 3, 4) between the resonant circuit (1) and a supply potential connection (8), **characterized in that** the current paths (2, 3, 4) each have a connection in series from one switch (4) each, an attenuation compensation amplifier and a current source (3) for feeding each attenuation compensation amplifiers (2).

2. Oscillator circuit according to Claim 1,
**characterized in that**
the switches (4) each have a control connection which is connected to a drive circuit (5).

3. Oscillator circuit according to Claim 1 or 2,
**characterized in that**
a control loop is formed with amplitude value detection (6) which is connected on the input side to the resonant circuit (1) and on the output side to the drive circuit (5).

4. Oscillator circuit according to one of Claims 1 to 3,
**characterized in that**
the current paths (2, 3, 4) with the attenuation compensation amplifiers (2) are connected in parallel with one another to the resonant circuit (1).

5. Oscillator circuit according to one of Claims 1 to 4,
**characterized in that**
the attenuation compensation amplifiers (2) each have two cross-coupled transistors (21).

6. Oscillator circuit according to Claim 5,
**characterized in that**
the transistors (21) in the attenuation compensation amplifiers (2) are field-effect transistors, which have the same channel width to channel length ratio that in pairs, with the channel width to channel length ratio of the attenuation compensation amplifiers (2) being graduated in binary steps with respect to one another.

7. Oscillator circuit according to one of Claims 1 to 6,
**characterized in that**
the switches (4) are digitally driven transistor switches.

8. Oscillator circuit according to one of Claims 1 to 7,
**characterized in that**
the resonant circuit (1) has a control input for controlling the resonant frequency by means of a control voltage (A).

## Revendications

1. Circuit oscillant compensé comprenant:
- un circuit (1) oscillant,
- plusieurs amplificateurs (2) de régénération, qui sont couplés de manière commutable respectivement au circuit (1) oscillant pour sa régénération, et
- respectivement un interrupteur (4), qui est associé respectivement à un amplificateur (2) de régénération et qui lui est couplé, pour la formation de respectivement un chemin (2, 3, 4) de courant pouvant être commuté efficacement, entre le circuit (1) oscillant et une borne (8) de potentiel d'alimentation,
- **caractérisé en ce que** les chemins (2, 3, 4) de courant comprennent respectivement un circuit série composé respectivement de l'amplificateur de régénération et d'une source (3) de courant pour alimenter l'amplificateur (2) respectif de régénération.

2. Circuit oscillant suivant la revendication 1, **caractérisé en ce que** les interrupteurs (4) ont respectivement une borne de commande, qui est reliée à un circuit (5) de commande.

3. Circuit oscillant suivant la revendication 1 ou 2, **caractérisé en ce qu'**il est formé une boucle de régulation ayant une détection (6) de valeur d'amplitude, qui est raccordée côté entrée au circuit (1) oscillant et côté sortie au circuit (5) de commande.

4. Circuit oscillant suivant l'une des revendications 1 à 3,
**caractérisé en ce que** les chemins (2, 3, 4) de courant ayant les amplificateurs (2) de régénération sont raccordés en étant montés en parallèle entre eux au circuit (1) oscillant.

5. Circuit oscillant suivant l'une des revendications 1 à 4,
**caractérisé en ce que** les amplificateurs (2) de régénération comprennent respectivement deux transistors (21) couplés transversalement.

6. Circuit oscillant suivant la revendication 5, **caractérisé en ce que** les transistors (21) des amplificateurs (2) de régénération sont des transistors à effet de champ, qui ont un rapport largeur du canal à longueur du canal qui est le même par paire, les rapports de la largeur à la longueur du canal des amplificateurs (2) de régénération entre eux étant étagés de façon binaire.

7. Circuit oscillant suivant l'une des revendications 1 à 6,
**caractérisé en ce que** les interrupteurs (4) sont constitués sous la forme de commutateurs à transistors commandés de façon numérique.

8. Circuit oscillant suivant l'une des revendications 1 à 7,
**caractérisé en ce que** le circuit (1) oscillant a une entrée de commande pour commander la fréquence d'oscillation par une tension (A) de commande.
